# EUROPEAN PATENT APPLICATION

(11) **EP 4 195 684 A1**
(43) Date of publication of application: **14.06.2023**
(21) Application number: 21854041.7
(22) Date of filing: 06.08.2021
(51) Int. Cl.: H04Q 1/04, H04Q 1/02, H04W 88/08, H01Q 1/42

(54) **BEAUTIFICATION DEVICE FOR BASE STATION COMMUNICATION APPARATUS**

(30) Priority: 06.08.2020 CN 202021627459 U
(71) Applicant: ZTE Corporation, Shenzhen, Guangdong 518057 (CN)
(72) Inventor: QIAO, Fengjiao, Shenzhen, Guangdong 518057 (CN); QIU, Xuemei, Shenzhen, Guangdong 518057 (CN); XUE, Feng, Shenzhen, Guangdong 518057 (CN)
(74) Representative: Ipsilon
(86) International application number: PCT/CN2021/111206
(87) International publication number: WO 2022/028575

(57) **Abstract**

Embodiments of the present disclosure provide a decorative apparatus for base station communication device, including: a fixed base; an upper cover body cooperating with the fixed base to form a first enclosed space; and a lower cover body cooperating with the fixed base to form a second enclosed space. The upper cover body includes: a fixed plate, a first movable plate connected to a left side of the fixed plate and rotatable around the left side of the fixed plate, a second movable plate connected to a right side of the fixed plate and rotatable around the right side of the fixed plate, and a top plate connected to an upper end of the fixed plate and fitted with an upper end of the first movable plate and an upper end of the second movable plate. The first enclosed space is internally provided with a device fixing assembly fixed to the fixed base and at least one communication device fixed to the device fixing assembly.

## Description

This application claims priority from Chinese patent application NO. 202021627459.1 filed on August 6, 2020, the entirety of which is incorporated herein by reference.

### TECHNICAL FIELD

Embodiments of the present disclosure relate to, but are not limited to, the field of communication technologies, and in particular relate to, but are not limited to, a decorative apparatus for base station communication device.

### BACKGROUND

With the development of the communication technology, the era of the 5th generation mobile networks (5G for short) has come, and the demands for base stations are increasing dramatically. As one of the densest infrastructures in the city, light pole has become the best carrier for deployment of 5G base station. How to integrate the base station and the light pole to better integrate them into city landscape, has become a great challenge for the base station to be deployed on the light pole. A decorative cover for a base station antenna can help the base station and the light pole to be integrated into city landscape, which can solve the problems of resident complaints and city appearance. However, the decorative cover for the base station antenna in the related art adopts a enclosed design, leading to problems such as difficult maintenance and replacement of the antenna, and the like.

### SUMMARY

An embodiment of the present disclosure provides a decorative apparatus for base station communication device.

In order to solve the above technical problems, an embodiment of the present disclosure provides a decorative apparatus for base station communication device, including: a fixed base; an upper cover body cooperating with the fixed base to form a first enclosed space; and a lower cover body cooperating with the fixed base to form a second enclosed space; wherein the upper cover body includes: a fixed plate, a first movable plate connected to a left side of the fixed plate and rotatable around the left side of the fixed plate, a second movable plate connected to a right side of the fixed plate and rotatable around the right side of the fixed plate, and a top plate connected to an upper end of the fixed plate and fitted with an upper end of the first movable plate and an upper end of the second movable plate; and the first enclosed space is internally provided with a device fixing assembly fixed to the fixed base and at least one communication device fixed to the device fixing assembly.

In some implementations, the device fixing assembly includes at least one of a support bar or a fixing bracket; the support bar has one end connected to the top plate and the other end connected to the fixed base; and the fixing bracket includes a mounting bracket connected to the fixed base, and an adapter bracket connected to the communication device, and the adapter bracket is connected to the mounting bracket via an adjusting assembly.

Additional features and corresponding beneficial effects of the present disclosure are set forth in the following description.

### BRIEF DESCRIPTION OF DRAWINGS

FIG. 1 is a schematic diagram of a decorative apparatus for base station communication device according to an embodiment of the present disclosure in a closed state;
FIG. 2 is a schematic diagram of a decorative apparatus for base station communication device according to an embodiment of the present disclosure in an open state;
FIG. 3 is a schematic structural diagram of a lower cover body according to an embodiment of the present disclosure;
FIG. 4 is a schematic assembly diagram of a communication device and a device fixing assembly according to an embodiment of the present disclosure;
FIG. 5 is a schematic structural diagram of a mounting bracket according to an embodiment of the present disclosure;
FIG. 6 is a schematic structural diagram of an adapter bracket according to an embodiment of the present disclosure;
FIG. 7 is a schematic assembly diagram of a mounting bracket and an adapter bracket according to an embodiment of the present disclosure.

### DETAIL DESCRIPTION OF EMBODIMENTS

For clarity and better understanding of objects, technical solutions and advantages of the present disclosure, embodiments of the present disclosure will be described in detail below with reference to specific implementations and accompanying drawings. It will be appreciated that the specific embodiments described herein are merely for illustration of the present disclosure and are not intended to limit the present disclosure.

In order to substantially solve the problems such as difficult maintenance and replacement of the antenna, and the like in the existing enclosed-type decorative covers for antennas, an embodiment of the present disclosure provides a decorative apparatus (or called beautification apparatus) for base station communication device, including: a fixed base; an upper cover body cooperating with the fixed base to form a first enclosed space; and a lower cover body cooperating with the fixed base to form a second enclosed space. By dividing the whole cover into an upper cover body and a lower cover body, the size of the whole cover is reduced, thereby facilitating assembly and transport of the cover.

The upper cover body includes: a fixed plate, a first movable plate connected to a left side of the fixed plate and rotatable around the left side of the fixed plate, a second movable plate connected to a right side of the fixed plate and rotatable around the right side of the fixed plate, and a top plate connected to an upper end of the fixed plate and fitted with an upper end of the first movable plate and an upper end of the second movable plate. By rotating the first movable plate and the second movable plate respectively around the fixed plate, an opening/closing structure is formed between the two movable plates, so that an opening/closing angle of a maintenance door in the decorative apparatus can be enlarged, and workers can conveniently maintain the communication device(s) inside the decorative apparatus, thereby the maintenance efficiency is improved.

The first enclosed space is internally provided with a device fixing assembly fixed to the fixed base and at least one communication device fixed to the device fixing assembly.

In some optional implementations, the device fixing assembly includes at least one of a support bar or a fixing bracket; the support bar has one end connected to the top plate and the other end connected to the fixed base; and the fixing bracket includes a mounting bracket connected to the fixed base and an adapter bracket connected to the communication device, and the adapter bracket is connected to the mounting bracket via an adjusting assembly. By means of the support bar and the fixing bracket, more than one communication devices may be placed in the decorative apparatus, and the mounting direction of each communication device can be changed through the adjusting assembly in the fixing bracket, so that the communication devices can be flexibly adjusted, the whole decorative apparatus can have a more compact structure while good network signals can be obtained.

In some optional implementations, the adjusting assembly includes a first set of adjusting holes disposed on the mounting bracket, a second set of adjusting holes disposed on the adapter bracket and corresponding to the first set of adjusting holes, and connectors disposed on the mounting bracket; and the connectors are respectively inserted into the first set of adjusting holes and the second set of adjusting holes, and slidable along the second set of adjusting holes. It will be appreciated that, on one hand, the mounting bracket is provided with the first set of adjusting holes, the adapter bracket is provided with the second set of adjusting holes, and when the mounting bracket is mounted on the adapter bracket, positions of the first set of adjusting holes need to correspond to positions of the second set of adjusting holes one by one, so as to implement accurate mounting of the adapter bracket and the mounting bracket. On the other hand, the connectors on the mounting bracket are inserted within the second adjusting holes, and when the connectors slide along the second set of adjusting holes, the adapter bracket is rotated relative to the mounting bracket. At this time, the communication device is also rotated along with the adapter bracket, thereby changing the mounting direction of the communication device. It will be appreciated that the mounting bracket and the adapter bracket may be rotatably connected in other ways, or may be fixedly connected to each other.

In some optional implementations, the first set of adjusting holes includes at least two first arcuate holes concentrically arranged, and the second set of adjusting holes includes at least two second arcuate holes concentrically arranged. It should be noted that the number of adjusting holes in each of the first set of adjusting holes and the second set of adjusting holes includes, but is not limited to, 2, 3, and 4, and each adjusting hole has a shape including, but not limited to, an arcuate shape or an annular shape. As an example, three first arcuate holes in the shape of accurate groove are uniformly arranged on the mounting bracket annularly, and correspondingly, three second arcuate holes in the shape of accurate groove are uniformly arranged on the adapter bracket annularly. In addition, the difference between a circle radius corresponding to an inner arc and a circle radius corresponding to an outer arc in each arcuate hole may be slightly larger than a maximum thickness of the corresponding connector, so as to enable the adapter bracket to be smoothly rotated relative to the mounting bracket. It will be appreciated that the specific number, shapes and positions of the adjusting holes may be set reasonably according to actual conditions.

In some optional implementations, the mounting bracket is provided with at least one positioning member, via which the communication device is plugged on the adapter bracket. It should be noted that the number of positioning members on the mounting bracket includes, but is not limited to, 4, 6, and 8. In some examples, the positioning members may each have a cylindrical shape, and evenly arranged on the mounting bracket in an annular shape. By providing a certain number of positioning members, the communication device can be accurately mounted on the adapter bracket, and when the adapter bracket is rotated relative to the mounting bracket, the communication device can be rotated synchronously with the adapter bracket, thereby facilitate angle adjustment of the communication device by a worker.

In some optional implementations, the support bar is provided with a mounting fastener, via which the communication device is fixed to the support bar. It should be noted that the mounting fastener may include one or more mounting lugs. In this case, an active antenna unit (AAU) or at least one remote radio unit (RRU), as an example of the communication device, may be placed inside the decorative apparatus, and mounted onto the support bar through the mounting lugs, so that the decorative apparatus may be compatible with a 4G or 5G AAU or RRU device. It will be appreciated that the communication device in the present disclosure is not limited to an AAU or RRU, but may be any other communication device, especially a base station communication device, or a combination of multiple communication devices.

In some optional implementations, the first movable plate and the second movable plate are respectively fixed to the fixed plate via at least two hinge members.

It should be noted that the hinge members may be a hinges. For example, the first movable plate and the second movable plate are connected to the fixed plate through two or three hinges, respectively. In addition, the first movable plate and the second movable plate may be connected with a detachable fastener. It will be appreciated that, when the communication device inside the decorative apparatus is desired to be maintained, the fastener between the first movable plate and the second movable plate may be firstly removed or unlocked, and then the first movable plate and the second movable plate are respectively pushed to be rotated around the fixed plate to predetermined positions, so that the communication device can be conveniently maintained by a worker.

In some optional implementations, the lower cover body includes three interconnected bottom plates, and each two adjacent bottom plates are connected by a fastener.

It should be noted that the lower cover body may include, but is not limited to, 2, 3 or 4 bottom plates, and each two adjacent bottom plates are connected with a detachable fastener. In some examples, a semi-enclosed lower cover body defined by several bottom plates may include an upper opening and a lower opening. The upper opening of the lower cover body may be connected to the fixed base, and the lower opening of the lower cover body may substantially conform to a pole (e.g., a light pole).

In some optional implementations, the decorative apparatus for base station communication device is mounted on a periphery of the light pole or on a top end of the light pole by welding, threading, screwing or the like.

In some optional implementations, at least one of the bottom plate, the fixed plate, the top plate, the first movable plate, or the second movable plate is provided with at least one heat dissipation hole.

It will be appreciated that any one or any combination of the plates in the upper cover body and the lower cover body may be provided with any number of heat dissipation holes, and in this case, heat generated by the communication device during operation can be discharged to the air through these heat dissipation holes, so that the heat dissipation requirement of the communication device is met.

In some optional implementations, the upper cover body and the lower cover body are made of fiberglass reinforced plastic.

It should be noted that the fixed base may be a flange chassis, and the upper cover body and the lower cover body are respectively connected to an outer sidewall of the flange chassis, so that surface smoothness and flatness of the upper cover body and the lower cover body are ensured, and an aesthetic degree of the decorative apparatus is improved. The decorative apparatus for base station communication device may be connected to a light pole through the flange chassis.

In some application scenarios, the decorative apparatus for base station communication device is in an open state, so that when a worker maintains the communication device, the first movable plate or the second movable plate may generate a rotary motion due to a large wind force or a false collision of the worker, which may easily cause the movable plate to collide with the flange chassis or other means and break. In order to avoid the above problem, a limiting means may be added between the upper cover body and the flange chassis, and the limiting means may be configured to limit the movable plate, so as to maintain an opening angle between the movable plate and the flange chassis. In some examples, the limiting means includes, but is not limited to, a pull-strap limiter or a torsion spring limiter. The torsion spring limiter may be integrated with the hinge. For example, a torsion bar is provided on the hinge, and when a movable plate is rotated around the fixed plate, different forces are generated through deformation of the torsion bar to achieve the limiting effect. In this case, the first movable plate or the second movable plate may interfere with the flange chassis while being rotated around the fixed plate, so that the problem that the first movable plate or the second movable plate, after being rotated outward to a preset angle, is easy to collide with the flange chassis and break due to wind power or a false collision of the worker, and safety of the two movable plates during operation is improved.

In some optional implementations, a lighting means is provided on the upper cover body and/or the lower cover body.

To maintain the communication device at night or in a dark environment, a lighting means may be provided on at least one of the upper cover body or the lower cover body. In some examples, the lighting means is provided on merely the upper cover body; in some examples, the lighting means is provided on merely the lower cover body; and in some examples, the lighting means is provided on both the upper cover body and the lower cover body. Meanwhile, the lighting means on the upper cover body and/or the lower cover body can play a role in decoration, and further improve aesthetic of the decorative apparatus for base station communication device. Furthermore, it will be appreciated that it is also possible that neither the upper cover body nor the lower cover body is provided with the lighting means.

In some optional implementations, the fixed base, the upper cover body and the lower cover body each have a cross section of a convex triangle shape, so as to consider both aesthetic perception and practicability of the means. It will be appreciated that the fixed base, the upper cover body and the lower cover body may each have a cross section of a triangle shape, a square shape, a diamond shape, a circular shape or any other shape.

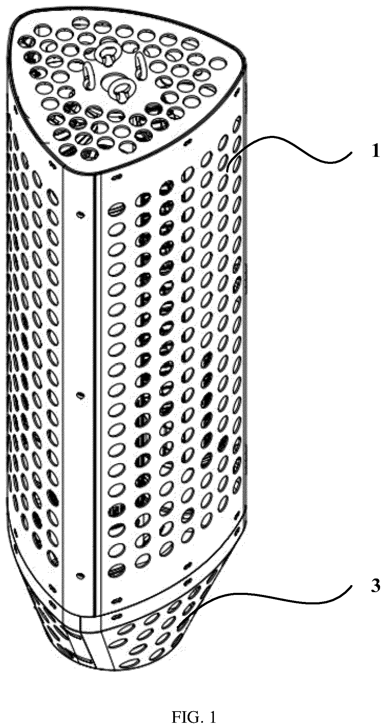

In order to better understand the decorative apparatus for base station communication device provided by the embodiments, an exemplary decorative apparatus for base station communication device is described in detail below with reference to FIGs. 1 to 7:

Referring to FIGs. 1 to 4, the decorative apparatus for base station communication device includes an upper cover body 1, a flange chassis (an example of the fixed base) 2, and a lower cover body 3. The upper cover body 1 includes a fixed plate 11, a first movable plate 12, a second movable plate 13, and a top plate 14. The lower cover body 3 includes three bottom plates 31. A plurality of heat dissipation holes are formed in the fixed plate 11, the first movable plate 12, the second movable plate 13, the top plate 14, and the bottom plate 31, respectively. The upper cover body 1, the flange chassis 2 and the lower cover body 3 each have a cross section of a convex triangle shape.

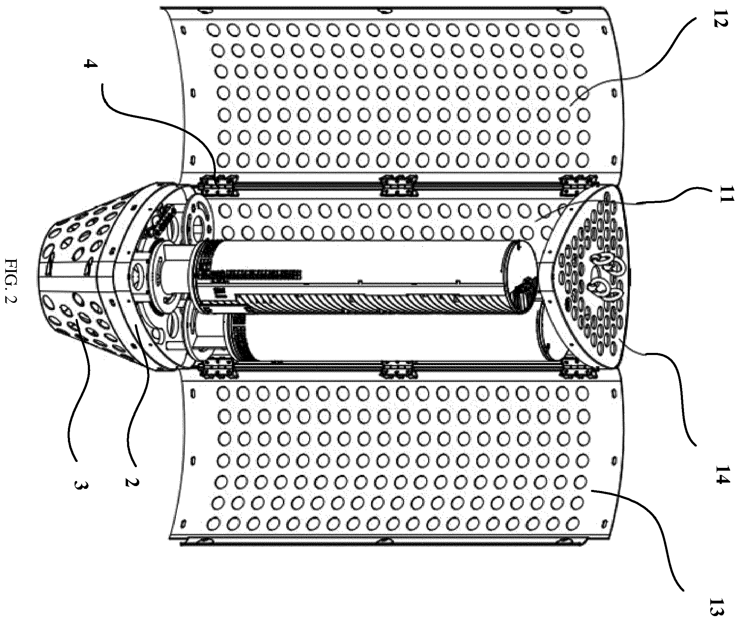

Referring to FIG. 2, the first movable plate 12 and the second movable plate 13 are respectively connected to the fixed plate 11 via three hinges 4, so that the first movable plate 12 and the second movable plate 13 are rotatable around the fixed plate 11, and the first movable plate 12 and the second movable plate 13 are adapted to the top plate 14 (in contact with an outer sidewall of the top plate 14). Meanwhile, when the decorative apparatus for base station communication device is in a closed state, a lower end of the first movable plate 12 and a lower end of the second movable plate 13 are both in contact with an outer sidewall of the flange chassis 2. The two movable plates may be connected to the flange chassis 2 through a limiting means (not shown), respectively. Meanwhile, the first movable plate 12 and the second movable plate 13 are both made of fiberglass reinforced plastic. When the first movable plate 12 or the second movable plate 13 is rotated around the fixed plate 11, under an action of the limiting means, the movable plate may interfere with the flange chassis, so that the problem that the first movable plate 12 or the second movable plate 13 is easy to collide with the flange chassis and break due to wind power or a false collision of the worker is solved, and safety of the two movable plates during operation is improved.

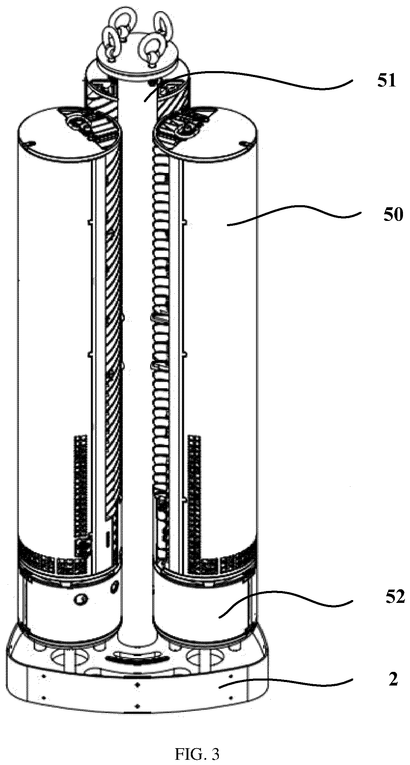

Referring to FIGs. 2 to 3, the upper cover body 1 and the flange chassis 2 cooperate to form a first enclosed space, and the flange chassis 2 is provided with three communication devices 50, a first device fixing assembly 51, and a second device fixing assembly 52. As shown in FIG. 3, the first device fixing assembly 51 is a support bar. When an AAU or at least one RRU is placed in the decorative apparatus for base station communication device, each communication device may be mounted on the support bar through a mounting lug. One support bar may be designed to mount one communication device (e.g., a cylindrical antenna) through a mounting lug, or may be designed to mount a plurality of communication devices (e.g., cylindrical antennas) through a plurality of mounting lugs.

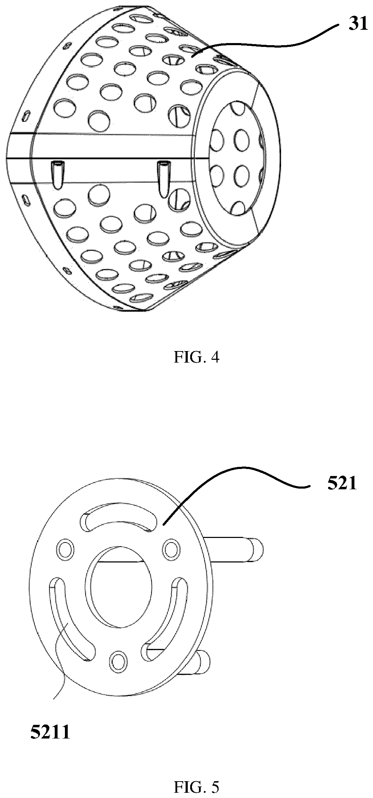

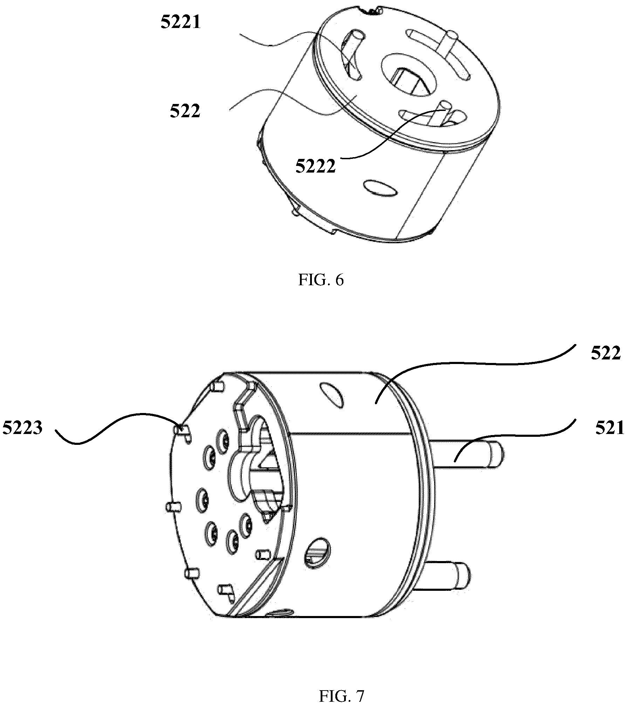

Referring to FIGs. 5 to 7, the second device fixing assembly 52 includes a mounting bracket 521 and an adapter bracket 522. FIG. 7 is a schematic structural diagram of the mounting bracket 521 and the adapter bracket 522 in connection. As shown in FIG. 5, the mounting bracket 521 is provided with three first arcuate holes 5211 concentrically arranged. As shown in FIGs. 6 and 7, the adapter bracket 522 is provided with three second arcuate holes 5221 concentrically arranged, cylindrical fasteners (example of connectors) 5222 inserted within the respective second arc-shaped holes 5221, and 6 cylindrical positioning members 5223 annularly arranged. Each positioning member 5223 is configured to fix the communication device 50 to the adapter bracket 522. When mounting the mounting bracket 521 onto the adapter bracket 522, positions of the first arcuate holes 5212 need to correspond to positions of the second arcuate holes 5221 one by one, so as to implement accurate mounting of the adapter bracket 522 and the mounting bracket 521. When the cylindrical fasteners 5222 slide along the second arcuate holes 5221, the adapter bracket 522 is rotated relative to the mounting bracket 521. At this time, the communication device 50 is also rotated along with the adapter bracket 522, thereby changing the mounting direction of the communication device.

In the decorative apparatus for base station communication device provided in the embodiments of the present disclosure, by providing a fixed base; an upper cover body cooperating with the fixed base to form a first enclosed space; and a lower cover body cooperating with the fixed base to form a second enclosed space, the whole cover is divided into an upper cover body and a lower cover body, and the size of the whole cover is reduced, thereby facilitating assembly and transport of the cover. The upper cover body includes: a fixed plate, a first movable plate connected to a left side of the fixed plate and rotatable around the left side of the fixed plate, a second movable plate connected to a right side of the fixed plate and rotatable around the right side of the fixed plate, and a top plate connected to an upper end of the fixed plate and fitted with an upper end of the first movable plate and an upper end of the second movable plate. By rotating the first movable plate and the second movable plate respectively around the fixed plate, an opening/closing structure is formed between the two movable plates, so that an opening/closing angle of a maintenance door in the decorative apparatus can be enlarged, and workers can conveniently maintain the communication device(s) inside the decorative apparatus, thereby improving the maintenance efficiency. The first enclosed space is internally provided with a device fixing assembly fixed to the fixed base and at least one communication device fixed to the device fixing assembly. The device fixing assembly includes at least one of a support bar or a fixing bracket. The support bar has one end connected to the top plate and the other end connected to the fixed base; and the fixing bracket includes a mounting bracket connected to the fixed base, and an adapter bracket connected to the communication device, and the adapter bracket is connected to the mounting bracket via an adjusting assembly. By means of the support bar and the fixing bracket, more than one communication devices may be placed in the decorative apparatus, and the mounting direction of each communication device can be changed through the adjusting assembly in the fixing bracket, so that the communication devices can be flexibly adjusted, the whole decorative apparatus can have a more compact structure while good network signals can be obtained.

The above are further detailed explanation of the embodiments of the present disclosure in conjunction with specific implementations, and the present disclosure is not to be construed as being limited to these implementations. For those ordinary skilled in the art to which the present disclosure pertains, several simple deductions or substitutions can be made without departing from the concept of the present disclosure, such deductions and substitutions should also be considered as falling within the scope of the present disclosure.

## Claims

1. A decorative apparatus for base station communication device, comprising: a fixed base; an upper cover body cooperating with the fixed base to form a first enclosed space; and a lower cover body cooperating with the fixed base to form a second enclosed space; wherein
the upper cover body comprises: a fixed plate, a first movable plate connected to a left side of the fixed plate and rotatable around the left side of the fixed plate, a second movable plate connected to a right side of the fixed plate and rotatable around the right side of the fixed plate, and a top plate connected to an upper end of the fixed plate and fitted with an upper end of the first movable plate and an upper end of the second movable plate; and
the first enclosed space is internally provided with a device fixing assembly fixed to the fixed base and at least one base station communication device fixed to the device fixing assembly.

2. The decorative apparatus for base station communication device according to claim 1, wherein the device fixing assembly comprises at least one of a support bar or a fixing bracket,
the support bar has one end connected to the top plate and the other end connected to the fixed base; and
the fixing bracket comprises a mounting bracket connected to the fixed base and an adapter bracket connected to the base station communication device, and the adapter bracket is connected to the mounting bracket via an adjusting assembly.

3. The decorative apparatus for base station communication device according to claim 2, wherein the adjusting assembly comprises a first set of adjusting holes disposed on the mounting bracket, a second set of adjusting holes disposed on the adapter bracket and corresponding to the first set of adjusting holes, and connectors disposed on the mounting bracket; and the connectors are respectively inserted within the first set of adjusting holes and the second set of adjusting holes, and slidable along the second set of adjusting holes.

4. The decorative apparatus for base station communication device according to claim 3, wherein the first set of adjusting holes comprises at least two first arcuate holes concentrically arranged, and the second set of adjusting holes comprises at least two second arcuate holes concentrically arranged.

5. The decorative apparatus for base station communication device according to any one of claims 2 to 4, wherein the adapter bracket is provided with at least one positioning member, via which the base station communication device is plugged on the adapter bracket.

6. The decorative apparatus for base station communication device according to claim 2, wherein the support bar is provided with a mounting fastener, via which the base station communication device is fixed to the support bar.

7. The decorative apparatus for base station communication device according to any one of claims 1 to 6, wherein the first movable plate and the second movable plate are respectively fixed to the fixed plate via at least two hinge members.

8. The decorative apparatus for base station communication device according to any one of claims 1 to 7, wherein the lower cover body comprises three interconnected bottom plates, and each two adjacent bottom plates are connected by a fastener.

9. The decorative apparatus for base station communication device according to claim 8, wherein at least one of the bottom plate, the fixed plate, the top plate, the first movable plate, or the second movable plate is provided with at least one heat dissipation hole.

10. The decorative apparatus for base station communication device according to any one of claims 1 to 9, wherein the upper cover body and the lower cover body are made of fiberglass reinforced plastic.

11. The decorative apparatus for base station communication device according to any one of claims 1 to 10, wherein a lighting means is provided on the upper cover body and/or the lower cover body.
